Europäisches Patentamt

European Patent Office

Office européen des brevets

(19)

(11) Veröffentlichungsnummer: **0 158 343 B1**

# (12) EUROPÄISCHE PATENTSCHRIFT

(45) Veröffentlichungstag der Patentschrift: **10.07.91**

(51) Int. Cl.5: **C08J 5/24, C08L 63/00**

(21) Anmeldenummer: **85104356.2**

(22) Anmeldetag: **10.04.85**

Die Akte enthält technische Angaben, die nach dem Eingang der Anmeldung eingereicht wurden und die nicht in dieser Patentschrift enthalten sind.

(54) **Verfahren zur Herstellung von mehrschichtigen Schichtpressstoffen und die dabei erhaltenen Schichtpressstoffe.**

(30) Priorität: **11.04.84 DE 3413639**

(43) Veröffentlichungstag der Anmeldung:
**16.10.85 Patentblatt 85/42**

(45) Bekanntmachung des Hinweises auf die
Patenterteilung:
**10.07.91 Patentblatt 91/28**

(84) Benannte Vertragsstaaten:
**AT BE CH DE FR GB IT LI LU NL SE**

(56) Entgegenhaltungen:
AT-A- 347 136          CH-A- 438 700
DE-A- 1 444 091        DE-A- 2 311 919
DE-A- 2 637 494        DE-A- 2 847 920
GB-A- 2 124 130        US-A- 3 523 037
US-A- 3 660 199

(73) Patentinhaber: **ISOLA WERKE AG**
**Isolastrasse 2**
**W-5160 Düren(DE)**

(72) Erfinder: **Hartmann, Helmut**
**Wilheim-Böhmer-Strasse 30**
**W-5166 Krezau-Bilstein(DE)**
Erfinder: **Frieder-Rouette, Paul, Dr.**
**Elsenborn 48**
**W-5100 Aachen(DE)**

(74) Vertreter: **TER MEER - MÜLLER - STEINMEI-STER & PARTNER**
**Mauerkircherstrasse 45**
**W-8000 München 80(DE)**

## Beschreibung

Gegenstand der Erfindung ist ein Verfahren zur Herstellung von mehrschichtigen Schichtpreßstoffen durch Verpressen von mit Epoxidharz imprägnierten Glasgewebebögen in der Hitze und im Vakuum.

Kupferkaschierte, mehrschichtige Schichtpreßstoffe, die als Basismaterialien für gedruckte Schaltungen eingesetzt werden, werden üblicherweise dadurch hergestellt, daß man die einzelnen Lagen aus dem betreffenden Trägermaterial, wie Papier oder Glasgewebe, mit einem hitzehärtbaren Harz imprägniert, das hitzehärtbare Harz unter Bildung eines Prepregs vorpolymerisiert und die Prepregs in einer von der angestrebten Enddicke des Schichtpreßstoffes abhängenden Anzahl aufeinander stapelt und in der Hitze verpreßt. Dabei sind der Herstellung von Schichtpreßstoffen mit hohem Harzgehalt Grenzen gesetzt, da das Verpressen bei schwimmender Lagerung erfolgt und damit die Gefahr des seitlichen Verschiebens der einzelnen Lagen oder gar des vollständigen Herausschiebens einer oder mehrer Lagen besteht. Hierbei ist zu berücksichtigen, daß auch das vorpolymerisierte imprägnierende Harz beim Verpressen in der Hitze zunächst schmilzt, wodurch ein Harzfluß erreicht wird, der zum Verbinden der verschiedenen Trägermaterialiallagen unter Bildung eines einheitlichen Schichtpreßstoffes, aber auch zur Entfernung der eingeschlossenen Gase und flüchtigen Bestandteile aus den Kanten notwendig ist. Aufgrund dieses Harzflusses ist es bei höherem Harzgehalt auch nicht mehr möglich, eine bestimmte Dickentoleranz einzuhalten, da das Harz an den Randzonen stärker ausfließt, wodurch die erzeugten Schichtpreßstoffe in der Mitte eine wesentlich größere Dicke als an den Rändern aufweisen. Aufgrund dieser Schwierigkeiten gibt es für die herkömmliche Herstellung von mehrschichtigen Schichtpreßstoffen begrenzende maximale Harzgehalte, die bei Epoxid-Glasgewebe-Schichtpreßstoffen bei dem Harzanteil liegen, der das Porenvolumen des Glasgewebes gerade ausfüllt.

Es besteht jedoch ein erhebliches Bedürfnis dafür, mehrschichtige Schichtpreßstoffe der oben angesprochenen Art mit einem höheren Harzgehalt herzustellen, da einerseits die Leistung der Imprägniermaschinen erhöht werden kann und andererseits die Dichten aufgrund eines höheren Harzanteiles vermindert werden können. Dabei wäre es von besonderem Vorteil, wenn es möglich wäre, insbesondere beim Aufbau von Glasgewebe-Epoxidharz-Schichtpreßstoffen bestimmte Dicken mit einheitlichen Glasgewebetypen einzustellen, was bislang nicht möglich war. So kann man die Standarddicke von 1,6mm bei Epoxidharz-Glasgewebe-Schichtpreßstoffen dadurch erreichen, daß man entweder acht bzw. neun Lagen eines Glasgewebes mit einem Flächengewicht von 200 bis 205 g/m$^2$ (beispielsweise die Glasgewebequalität 7628) oder sieben Lagen eines entsprechenden Gewebes mit doppelt starkem Schußfaden und damit einem Flächengewicht von etwa 236 g/m$^2$ (beispielsweise die Glasgewebequalität 7637) vorsieht. Da nun die letztgenannte Glasgewebequalität eine wesentlich gröbere Gewebestruktur aufweist, ergeben sich Nachteile durch eine größere Oberflächenwelligkeit und eine schlechtere Bohrbarkeit. Es besteht daher ein erhebliches Bedürfnis dafür, qualitativ hochwertige Epoxidharz-Glasgewebe-Schichtpreßstoffe mit enger Dickentoleranz auch bis in die Randbereiche unter Verwendung von lediglich sieben Lagen des Glasgewebes mit feiner Gewebestruktur herzustellen. Dem stand jedoch bislang ein Vorurteil entgegen, da Glasgewebelagen mit überproportional viel Harz, wie beschrieben, nicht gut verarbeitbar sind. Entweder ist die Viskosität des geschmolzenen Harzes zu gering, dann läuft es aus den Glaslagen heraus, oder die Viskosität ist zu hoch, dann wird die beim Stapeln eingeschlossene Luft nicht heraustransportiert. Außerdem entstehen Gaspolster, die den gefürchteten Schiebefluß bewirken können. Im ersten Fall werden die Laminate zu dünn, es entsteht Harzverlust. Im zweiten Fall enthalten die Laminate Bläscheneinschlüsse, die bei der Weiterverarbeitung nicht toleriert werden können. Bei Schiebefluß schließlich entsteht meist Totalausfall. Der ideale Harzzustand für "mehr Harz" ist angesichts technisch bedingter Toleranzen im Großbetrieb nicht beherrschbar - sofern er überhaupt existiert.

Es ist allerdings aus dem DE-GM 83 07 901 bekannt, daß man bei der Herstellung von Schichtpreßstoffen Rahmen verwenden kann, die ein seitliches Verschieben der Prepregs durch starken Harzfluß beim Pressen in der Wärme verhindern sollen, und daß es auch möglich ist, bei der Herstellung dünner kupferkaschierter schichtpreßstoffe auf Epoxid- und Polyimidharzbasis Vakuumrahmen zu verwenden, die die Bildung von Blasen und Hohlräumen beim Preßvorgang vermeiden sollen, wobei den Prepregs eventuelle Restfeuchte entzogen werden und die Oxidation der Kupferfolie bei den hohen Preßtemperaturen infolge Eindringens von Luftsauerstoff in die Randzonen verhindert werden sollen. Bezüglich der Herstellung von mehrschichtigen Schichtpreßstoffen mit erheblich erhöhtem Harzgehalt gibt diese Literaturstelle jedoch nichts her, zumal der Fachmann bei Anwendung eines höheren Harzgehaltes auch mit einem höheren Harzfluß rechnen wird, so daß er davon absehen wird, einen das seitliche Verschieben der Prepregs verhindernden Rahmen oder einen Vakuumrahmen vorzusehen, da ja bei einem höheren Harzgehalt gerade in diesen Randbereichen mit einem stärkeren Austreten des Harzes und damit mit einem Verkleben des Harzes mit dem Rahmen gerechnet werden muß.

Die DE-OS 2 637 494 beschreibt ein Verfahren zur Herstellung von kaltschneidbaren, elektrisch hochwertigen Schichtpreßstoffen auf der Grundlage von Bahnen aus Zellulosematerialien, gemäß dem die zu imprägnierende Bahn zunächst einem Penetriervorgang mit einer Lösung eines Penetrierharzes in Mengen von 4 bis 20 % unterworfen wird, wonach die in dieser Weise vorimprägnierte Bahn mit einer zweiten Harzlösung beladen, dann getrocknet und schließlich verpreßt wird. Aufgrund der Anwendung von Zellulosematerialien mit ihrem von vorneherein erheblich höheren Porenvolumen ist es möglich, hohe Harzaufträge zu erreichen, umso mehr, als die Bahn aus dem Zellulosematerial durch das Harz aufquillt.

Gegenstand der DE-OS 23 11 919 ist ein glasfaserverstärktes Epoxy-Laminat mit einer relativ dicken beidseitigen Kunststoffdeckschicht auf Epoxybasis, welches dadurch hergestellt wird, daß ein provisorischer Träger mit einen Epoxidharz beschichtet wird, welches so weit ausgehärtet wird, daß seine Fließfähigkeit beim hachfolgenden Preßvorgang verringert wird, worauf dieser provisorische Träger unter Wärmeeinwirkung auf beide Seiten einer endgültigen Grundplatte aufgepreßt wird, wobei die epoxidharzbeschichtete Oberfläche des provisorischen Trägers zur endgültigen Grundplatte hin gerichtet ist. Dieses Verfahren ermöglicht zwar die Ausbildung von glasfaserverstärkten Epoxy-Laminaten mit dicken außenliegenden Epoxidharzschichten, erlaubt jedoch nicht die Herstellung von Schichtpreßstoffen mit homogener Verteilung von Harz- und Glasgewebematerial oder die Anwendung hoher Harzgehalte im Inneren und leidet weiterhin an dem Nachteil, daß aufgrund der außen aufgebrachten dicken Harzschichten ein nicht ungefährliches Verrutschen der imprägnierten Glasgewebebögen möglich ist.

Die CH-PS 438 700 lehrt eine kupferkaschierte Schichtpreßstoff-Tafel mit hohem Harzgehalt, der dadurch erreicht wird, daß neben den Glasfasermatten auch hochimprägnierbare Isolierpapiere eingesetzt werden. Sowohl Glasfasermatten, wie auch die Papiere haben infolge ihres hohen Porenvolumens ein erheblich höheres Harzaufnahmevermögen als Glasgewebe, so daß die Harz/Träger-Relation der CH-PS 438 700 nicht problemlos auf Glasgewebe übertragen werden kann.

Die DE-A-2 847 928 beschreibt eine verformbare dekorative Kunstharz-Schichtpreßstoffplatte, die aus mehreren miteinander verpreßten, mit duroplastischen Bindemitteln imprägnierten Papieren aufgebaut ist.

Die Aufgabe der vorliegenden Erfindung besteht nun darin, das Verfahren der eingangs angegebenen Gattung derart zu verbessern daß es gelingt, bei Einhaltung der notwendigen Dickentoleranz den Harzgehalt eines mehrschichtigen Schichtpreßstoffes erheblich zu steigern und die hierbei auftretenden Probleme des Harzausflusses bzw. des Vershiebens der einzelnen Glasgewebebögen zu verhindern.

Es hat sich nun überraschenderweise gezeigt, daß diese Aufgabe dadurch gelöst werden kann, daß man die Glasgewebebögen auf einen Harzgehalt oberhalb der durch das Porenvolumen der Glasgewebebögen gegebenen Sättigungsgrenze imprägniert und das Harz auf eine ungewöhnlich hohe Viskosität vorpolymerisiert, wodurch es möglich wird, die imprägnierten Glasgewebebögen bei vermindertem Harzausfluß unter Vakuum ohne die Gefahr des seitlichen Verschiebens der einzelnen Glasgewebebögen zu verpressen.

Beim Verpressen solcher Glasgewebebögen im Vakuum wird es überraschenderweise nicht nur möglich, die Gefahr des seitlichen Verschiebens der harzimprägnierten Glasgewebebögen zu verhindern und eine gleichmäßige Dickentoleranz über die gesamte Breite des Schichtpreßstoffes zu erreichen, da praktisch kein Austrten des Harzes in den Randbereichen erfolgt, sondern auch ein blasenfreies, qualitativ hochwertiges Produkt zu erhalten, was aufgrund der angewandten erhöhten Schmelzviskosität und des damit vorliegenden höheren Polymerisationsgrades des imprägnierenden Epoxidharzes nicht erwartet werden konnte.

Gegenstand der Erfindung ist daher ein Verfahren zur Herstellung von mehrschichtigen Schichtpreßstoffen durch Verpressen von mit Epoxidharz imprägnierten Glasgewebebögen in der Hitze und im Vakuum, das dadurch gekennzeichnet ist, daß man die Glasgewebebögen auf einen Harzgehalt oberhalb der durch das Porenvolumen der Glasgewebebögen gegebenen Sättigungsgrenze imprägniert, das Harz auf eine in 65%iger Lösung in Dimethylformamid bei 25°C gemessene Viskosität von 1900 bis 2400 mPa•s vorpolymerisiert und die aufeinandergestapelten imprägnierten Glasgewebebögen verpreßt.

Namentlich wird es mit Hilfe des erfindungsgemäßen Verfahrens möglich, einen mehrschichtigen, vorzugsweise kupferkaschierten Schichtpreßstoff herzustellen, der sieben mit einem Epoxidharz verbundene Lagen aus einem Glasgewebe mit einem Flächengewicht von 200 bis 205 g/m² umfaßt und eine Standarddicke von 1,5 bis 1,6 mm aufweist und der damit bei Anwendung des bevorzugten feinstrukturierten Glasgewebes eine Glasgewebelage weniger enthält als es bislang möglich war.

Bei dem erfindungsgemäßen Verfahren werden zunächst die Glasgewebebögen auf einen Harzgehalt imprägniert, der oberhalb der Sättigungsgrenze liegt, die durch das Porenvolumen der Glasgewebebögen gegeben ist. Dabei ist unter diesem Porenvolumen die Differenz zwischen dem scheinbaren Volumen des Glasgewebebogens (Länge x Breite x Höhe) und dem Volumen des Glases des Glasgewebebogens zu verstehen. Erfindungsgemäß werden die Glasgewebebögen über die durch dieses Porenvolumen definierte Sättigungsgrenze hinaus imprägniert, das heißt, es wird eine Epoxidharzmenge aufgebracht, die größer ist als das freie Porenvolumen des Glasgewebebogens, wobei der Harzgehalt vorzugsweise 30 bis 45 Vol.% oberhalb der Sättigungsgrenze liegt, das heißt, um diesen Prozentsatz größer ist als das freie Porenvolumen des eingesetzten Glasgewebes, welches als 100 Vol.% anzusetzen ist, so daß sich bei einem Harzgehalt von 30 Vol.% oberhalb der Sättigungsgrenze ein Harzgehalt von 130 Vol.% ergibt. Dieser Harzauftrag führt bei einem Glasgewebe von 200 bis 205 g/m² zu einem Harzgehalt von ca. 45 bis 60 Gew.-%, wobei insbesondere ein Harzgehalt von 50 ± 1 Gew.-% bevorzugt ist.

Erfindungsgemäß werden die auf den oben angesprochenen Harzgehalt imprägnierten Glasgewebebögen anschließend durch eine Wärmebehandlung auf eine Viskosität von 1900 bis 2400 mPa . s und bevorzugter von 2000 bis 2200 mPa . s gebracht, wobei die Viskosität mit Hilfe eines Höppler-Kugelfallviskosimeters an einer 65-%igen Lösung des Harzes in Dimethylformamid bei 25°C gemessen wird. Diese erfindungsgemäß eingestellte Viskosität des imprägnierenden Epoxiharzes liegt wesentlich höher als es bei den Methoden des Standes der Technik üblich ist, wo Harze auf eine Viskosität von 1550 bis 1650 mPa . s vorpolymerisiert werden.

Bevorzugt wird das imprägnierende Epoxiharz erfindungsgemäß auf eine Viskosität von 2000 bis 2100 mPa . s vorpolymerisiert. Dies führt zu einer überproportionalen Erniedrigung der Gelierzeit um etwa 30 bis 35%, also zum Beispiel von 125 auf 85 Sekunden.

Überraschend ist hierbei, daß trotz des höher polymerisierten Harzbestandteils die notwendige Blasenfreiheit des Schichtpreßstoffes ohne weiteres erreicht werden kann, was den Fachmann auch bei Berücksichtigung der Tatsache des Anlegens eines Vakuums überraschen muß, da aufgrund der höheren Schmelzviskosität des Harzbestandteils das vollständige Auswandern der gasförmigen bzw. flüchtigen Bestandteile aus den imprägnierten Glasgewebebögen nicht erwartet werden konnte, weil ja gleichzeitig der Aushärtvorgang des Harzbestandteils abläuft, der aufgrund der stärkeren Vorpolymerisation schon zu Beginn des Verpressens erheblich weiter fortgeschritten ist.

In der nachfolgenden Tabelle sind für unterschiedliche, der handelsübliche Glasgewebetypen die Porenvolumina und die Harzgehalte angegeben, die sich bei Anwendung von zwei Epoxidharzen unterschiedlicher Dichte ergeben, wenn man einen der Sättigungsgrenze entsprechenden Harzauftrag anwendet, das heißt, das freie Porenvolumen des

Glasgewebes gerade mit dem Epoxidharz ausfüllt:

Berechnung der theoretischen Harzmenge, die das Glasgewebe ausfüllt, ohne es aufzudicken

| Gewebe-typ | m²-Gew. (g) | Glas-volumen D=2,54 (cm³) | Dicke (mm) | schein-bares Glasvol- (cm³) | Porenvolumen E-C (cm³) | als % des scheinb. Glas-volumens | Füllung mit leichtem Harz d=1,17 g/ml (g) | Harzgeh. (Gew.-%) | Füllung mit schwerem Harz d=1,79 g/ml (g) | Harzgeh. (Gew.-%) |
| --- | --- | --- | --- | --- | --- | --- | --- | --- | --- | --- |
| A | B | C | D | E | F | G | H | I | K | L |
| 7628 | 202 | 79,5 | 0,180 | 180 | 100,5 | 55,8 | 117,6 | 36,8 | 179,9 | 47,1 |
| 1528 | 202 | 79,5 | 0,170 | 170 | 90,5 | 53,2 | 105,9 | 34,4 | 162,0 | 44,5 |
| 1675 | 99 | 39 | 0,120 | 120 | 81 | 67,5 | 94,8 | 48,9 | 145,0 | 59,4 |
| 2112 | 70 | 27,6 | 0,075 | 75 | 47,4 | 63,2 | 55,5 | 44,2 | 84,8 | 54,8 |

Als weiterer überraschender Effekt ist die Tatsache anzusehen, daß sich bei Anwendung des erfindungsgemäßen Verfahrens eine höhere Glasübergangstemperatur (Tg) des ausgehärteten Harzes einstellt, die um etwa 3 bis 5 % höher liegt, als bei dem bislang üblichen Verpressen der harzimprägnierten Glasgewebebögen ohne die Anwendung eines Vakuums.

Bei dem erfindungsgemäßen Verfahren ist es weiterhin nicht nötig, das Vakuum während des gesamten Preßvorgangs aufrechtzuerhalten, da es genügt, das Vakuum nur während des eigentlichen Schmelzprozesses anzulegen.

Gegenstand der Erfindung sind weiterhin die nach dem erfindungsgemäßen Verfahren erhältlichen mehrschichtigen Schichtpreßstoffe aus sieben mit einem Epoxidharz verbundenen Lagen aus einem Glasgewebe mit einem Flächengewicht von 200 bis 205 $gm^2$ und einer Dicke von 1,5 bis 1,6 mm.

Das folgende Beispiel dient der weiteren Erläuterung der Erfindung.

BEISPIEL

Ein Glasgewebe (US-Nr. 7628 , mit einem Quadratmetergewicht von 202 g und einer Fadenstellung von 17 x 12 pro cm) wird auf einer für die Schichtpreßstoffherstellung üblichen Imprägniermaschine mit einer Epoxidharzlösung imprägniert. Die Epoxidharzlösung enthält ein bromiertes Harz mit einem Bromgehalt von 18 %, einer Dichte von 1,42 g/ml und einer Viskosität von 244 ± 4 mPa . s (bestimmt mit Hilfe eines Kugelfallviskosimeters in einer 65-%igen Lösung des Harzes in Dimethylformamid bei 25 °C). Auf 100 Gew.-Teile des Harzes werden 3,5 % Dicyandiamid und 0,2 % Benzyldimethylamin verwendet. Die auf einer glatten Eisenplatte gemessene Gelierzeit dieser Harzlösung beträgt bei 170 °C 170 ± 10 Sekunden. Die Imprägniermaschine arbeitet in der Trockenstrecke bei einer Maximaltemperatur von 180 °C.

Wie aus der obigen Tabelle hervorgeht, beträgt das Porenvolumen des eingesetzten Glasgewebes (7628) ca. 100,5 $cm^3/m^2$. Es wird dann 202 $g/m^2$ Festharz mit Härter und Beschleuniger aufgetragen, dabei entsteht ein Harzgehalt von etwa 50 Gewichtsprozent. Von dieser Harzmenge sind ca. 60 $g/m^2$, entsprechend 42,2 $cm^3$ über der Sättigungsgrenze des Glasgewebes, das entspricht 142 Vol.% des Porenvolumens.

Das Harz wird auf ca. 2000 mPa . s (in 65%-iger DMFA-Lösung, gemessen im Höppler-Kugelfallviskosimeter) vorpolymerisiert und besitzt dann eine Gelierzeit von 85 Sekunden bei 170 °C und einen Schmelzpunkt von 65 °C. Die Verweilzeit im Trockenkanal war dabei etwa 1,6 Minuten.

Die in dieser Weise hergestellten Glasgewebe-Prepregs werden unter Anwendung der nachfolgend angegebenen Preßbedingungen zu Schichtpreßstoffen verarbeitet, wobei zu Vergleichszwecken ein in herkömmlicher Weise imprägniertes Glasgewebe-Prepreg eingesetzt wird, dessen Epoxidharz eine Viskosität von 1600 mPa • s aufweist. Der Harzgehalt beträgt 41,5 Gew.-% und füllt gerade das Porenvolumen. Die Gelierzeit des Standardmaterials beträgt dabei 125 Sekunden bei 170 °C.

|  | gemäß Erfindung | Stand der Technik |
|---|---|---|
| Anzahl der Prepregs | 7 | 9 |
| Aufheizgeschwindiakeit der Heizplatten ($^{o}$C/min) | 50 | 5 |
| Gesamtheizzeit (min) | 90 | 105 |
| Härtungstemperatur (°C) | 176 | 176 |
| Preßdruckaufbau (bar/min) | 2,5 | 10 |
| Preßdruck | 44 | 52 |
| Vakuum kleiner 40 mbar ab Start (min) | 15 | - |

Die entstehenden blasenfreien Schichtpreßstoffe ergeben bei Belegung mit 35 $\mu$m dicken Kupferfolien eine Dicke von 1,6 mm bei einer Toleranz von ± 0,08 mm.

Spez. Gewicht (g/ml)  1,80  1,90.

**Ansprüche**

1. Verfahren zur Herstellung von mehrschichtigen Schichtpreßstoffen durch Verpressen von mit Epoxidharz imprägnierten Glasgewebebögen in der Hitze und im Vakuum, **dadurch gekennzeichnet**, daß man die Glasgewebebögen auf einen Harzgehalt oberhalb der durch das Porenvolumen der Glasgewebebögen gegebenen Sättigungsgrenze imprägniert, das Harz auf eine in 65%iger Lösung in Dimethylformamid bei 25°C gemessene Viskosität von 1900 bis 2400 mPa •s vorpolymerisiert und die aufeinandergestapelten imprägnierten Glasgewebebögen verpreßt.

2. Verfahren nach Anspruch 1,
   **dadurch gekennzeichnet**, daß man die Glasgewebebögen auf einen Harzgehalt von 30 bis 45 Vol.-% oberhalb der Sättigungsgrenze imprägniert.

3. Verfahren nach den Ansprüchen 1 oder 2,
   **dadurch gekennzeichnet**, daß man das Harz auf eine Viskosität von 2000 bis 2200 mPa • s vorpolymerisiert.

4. Verfahren nach den Ansprüchen 1 bis 3,
   **dadurch gekennzeichnet**, daß das Vakuum nur während des Schmelzprozesses angelegt wird.

5. Mehrschichtiger Schichtpreßstoff erhältlich nach dem Verfahren gemäß den Ansprüchen 1 bis 4.

6. Mehrschichtiger Schichtpreßstoff nach Anspruch 5,
   **dadurch gekennzeichnet**, daß er sieben mit einem Epoxidharz verbundene Lagen aus einem Glasgewebe mit einem Flächengewicht von 200 bis 205 g/m² umfaßt und eine Dicke von 1,5 bis 1,6 mm aufweist.

**Claims**

1. Process for producing multilayer moulded laminates by press-moulding glass cloth sheets impregnated with epoxy resin, in vacuo while hot, characterised in that the glass cloth sheets are impregnated to a resin content above the saturation limit given by the pore volume of the glass cloth sheets, the resin is prepolymerized to a viscosity of 1900 to 2400 mPa.s measured in a 65%-strength solution in dimethylformamide at 25°C and the impregnated glass cloth sheets stacked one above the other are press-moulded.

2. Process according to Claim 1, characterised in that the glass cloth sheets are impregnated to a resin content of 30 to 45% by volume above the saturation limit.

3. Process according to Claim 1 or 2, characterised in that the resin is prepolymerized to a viscosity of 2000 to 2200 mPa.s

4. Process according to Claims 1 to 3, characterised in that the vacuum is applied only during the melting process.

5. Multilayer moulded laminate obtainable by the process according to Claims 1 to 4.

6. Multilayer moulded laminate according to Claim 5, characterised in that it comprises seven layers of a glass cloth with a weight per unit area of 200 to 205 g/m² which are bonded by means of an epoxy resin and has a thickness of 1.5 to 1.6 mm.

**Revendications**

1. Procédé de fabrication de stratifiés multicouche par compression à chaud et sous vide de feuilles de tissu de verre imprégnées de résine époxy, caractérisé en ce que l'on imprègne les feuilles de tissu de verre jusqu'à obtenir une teneur en résine supérieure à la limite de saturation conditionnée par le volume de pores des feuilles de tissu de verre, en ce que l'on prépolymérise la résine jusqu'à une viscosité de 1900 à 2400 mPa.s, mesurée à 25°C dans une solution de diméthylformamide à 65 %, at en ce que l'on comprime les feuilles de verre imprégnées ampilées les unes sur les autres.

2. Procédé selon la revendication 1, caractérisé en ce que l'on imprègne les feuilles de tissu de verre jusqu'à obtenir une teneur en résine supérieure de 30 à 45 % en volume à la limite de saturation.

3. Procédé selon l'une des revendications 1 ou 2, caractérisé en ce que l'on prépolymérise la résine jusqu'à obtenir une viscosité de 2000 à 2200 mPa.s.

4. Procédé selon les revendications 1 à 3, caractérisé en ce que l'on applique le vide seulement pendant la fusion.

5. Stratifié multicouche obtenu d'après le procédé selon les revendications 1 à 4.

6. Stratifié multicouche selon la revendication 5, caractérisé en ce qu'il comporte 7 couches, liées avec une résine époxy, d'un tissu de verre de poids surfacique 200 à 205 g/m², et qu'il présente une épaisseur de 1,5 à 1,6 mm.